# EUROPEAN PATENT SPECIFICATION

(11) **EP 0 902 483 B1**
(45) Date of publication and mention of the grant of the patent: **12.11.2008**
(21) Application number: 97850130.2
(22) Date of filing: 11.09.1997
(51) Int. Cl.: H01L 29/94, H03B 5/12, H03L 7/099

(54) **Electrical device comprising a voltage dependant capacitance and method of manufacturing the same**
Elektrische Anordnung mit einer spannungsabhängiger Kapazität und Verfahren zur Herstellung
Dispositif électrique comprenant une capacité de la tension et procédé de fabrication

(43) Date of publication of application: 17.03.1999
(60) Divisional application: 08158618.2
(73) Proprietor: TELEFONAKTIEBOLAGET LM ERICSSON (publ), 164 83 Stockholm (SE)
(72) Inventor: Litwin, Andrej, 182 35 Danderyd (SE); Mattisson, Sven Erik, 237 32 Bjärred (SE)
(74) Representative: Bratt, Hanna Catharina

(56) References cited:
- EP-A- 0 208 935
- FR-A- 2 541 514
- US-A- 5 045 966
- US-A- 5 107 227
- PATENT ABSTRACTS OF JAPAN vol. 18, no. 425 (E-1590), 9 August 1994 & JP 06 132728 A (SANYO ELECTRIC CO LTD), 13 May 1994,

## Description

### TECHNICAL FIELD OF INVENTION

The present invention relates to varactors and, in particular, to varactors suitable for integration. This kind of varactors are found, for example, in Voltage Controlled Oscillators and Phase Locked Loop circuits which, in their turn, are often used in radio communication devices. The present invention also relates to the manufacturing of such devices.

### DESCRIPTION OF RELATED ART

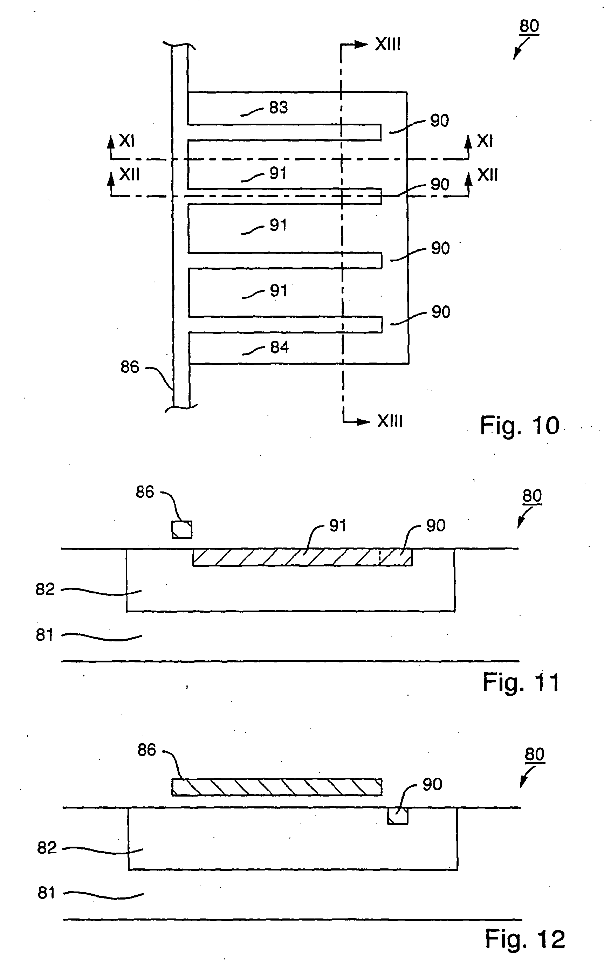

A varactor is an electrical device having a capacitance which is controlled by a suitable voltage or current bias. A varactor is used, for example, in Voltage Controlled Oscillators, VCO:s, where a frequency of an oscillator is controlled by an applied voltage or current bias. VCO:s are used, for example, when a variable frequency is required or when a signal needs to be synchronised to a reference signal. In radio communication devices, *e.g.* portable/cellular phones, VCO:s are often used in Phase Locked Loop, PLL, circuits to generate suitable signals. Generation of a reference signal which is synchronised with a signal received by a radio receiver, modulation/demodulation operations and frequency synthesis are examples of such uses. Several varactors suitable for Integrated Circuit, IC, technologies are known in the prior art. R. A. Molin and G. F. Foxhall discuss in "Ion-Implanted Hyperabrupt Junction voltage Variable Capacitors", IEEE Trans. Electron Devices, ED-19, pp. 267f, 1972, the use of pn-diodes as varactors which may be used in bipolar, CMOS or BiCMOS technologies. It is also known to use Schottky diodes or MOS-diodes as varactors. The latter is described, for example, by S. M. Sze in "Physics of Semiconductor Devices" John Wiley & Sons, 2nd Edition, pp. 368f. The integration of the known varactors depends on the capability of the IC technology. An overview of the integrated devices for high frequency RF application in a BiCMOS process is given by J. N. Burghartz, M. Soyuer and K. Jenkins in "Integrated RF and Microwave Components in BiCMOS Technology", IEEE Trans. Electron Devices, Vol. 43, pp. 1559-1570, Sept. 1996. As is stated on page 1568 and in figure 12 the varactors are not a part of the standard BiCMOS device set. Instead it is proposed to use a collector-base junction of a bipolar transistor as a varactor. J. Craninckx and M. S. J. Steyaert suggests in "A 1.8-GHz Low-Phase-Noise CMOS VCO Using Optimized Hollow Spiral Inductors", IEEE J. Solid-State Circuits, Vol. 32, pp. 736-744, May 1997, the use of a p+/n-well junction diode as a varactor in a VCO which is integrated by means of a CMOS process.

D3 discloses a VCO with MOS capacitors formed on an N-type semiconductor substrate.

Whilst the known form of varactors described above functions quite adequately, they do have a number of disadvantages.

One drawback of the known varactors is that they are difficult to realise with high quality factors, Q, especially for high frequency applications in a conventional CMOS process due to their high series resistance or required additional manufacturing steps. This results in low yield and high manufacturing costs.

Another drawback of the known pn-junction varactors is that in many applications, such as when used in most VCO circuits, a DC de-coupling capacitor needs to be added to the design which makes the design even more difficult to integrate into an IC. The use of a DC de-coupling capacitor externally to the IC adds on to the overall cost of the implementation and consumes valuable space on a Printed Circuit Board, PCB. These drawbacks becomes even more pronounced in hand-held devices, such as portable phones, which need to be small and which are produced in high-volumes.

It is an object of the present invention to provide a varactor which overcomes or alleviates the above mentioned problems.

### SUMMARY OF THE INVENTION

The present invention is defined in the independent claims 1 and 14. Advantageous embodiments are given in the depending claims.

An advantage of the present invention is that a varactor having a high quality factor, Q, *i.e.* with low series resistance, may be realised even for high frequency applications by using a conventional CMOS process without adding any manufacturing steps. The varactors may therefore be manufactured at high yield and to low costs.

Furthermore, an advantage of the present invention is that a VCO is provided which may be realised by using a conventional CMOS process and which does not need a DC de-coupling capacitor in the design. This makes the implementation of the VCO inexpensive and physically small since no DC de-coupling capacitor is needed neither on the IC nor externally to the IC on a PCB. These advantages becomes even more pronounced when implemented in hand-held devices, such as portable phones, which need to be small and which are produced in high-volumes.

Advantageously, the present invention provides an integrated Voltage Controlled Oscillator and/or Phase Locked Loop, PLL, circuit, which include a varactor as discussed above, by using a conventional CMOS process.

Since many of the functions of a radio communication device may be integrated by conventional CMOS processes, the integration of a VCO and/or a PLL circuits together with these functions allows the present invention to provide a radio communication device with a high degree of integration and thus small physical dimensions. The high degree of integration also reduces the manufacturing costs.

### BRIEF DESCRIPTION OF THE DRAWINGS

FIG 1 illustrates a varactor comprising a PMOS enhancement transistor;
FIG 2 illustrates a varactor comprising a NMOS enhancement transistor;
FIG 3 illustrates a varactor comprising a NMOS depletion transistor;
FIG 4 illustrates an operational aspect of the varactor of fig. 1;
FIG 5 illustrates an equivalent circuit diagram of the varactor of fig. 1;
FIG 6 illustrates a circuit diagram of a Voltage Controlled Oscillator according to a first embodiment of the present invention;
FIG 7 illustrates a top-view of a composite varactor according to a second embodiment of the present invention;
FIG 8 illustrates a cross-section view along the axis VIII-VIII of FIG 7;
FIG 9 illustrates a cross-section view along the axis IX-IX of FIG 7;
FIG 10 illustrates a top-view of a composite varactor according to a third embodiment of the present invention;
FIG 11 illustrates a cross-section view along the axis XI-XI of FIG 10;
FIG 12 illustrates a cross-section view along the axis XII-XII of FIG 10;
FIG 13 illustrates a cross-section view along the axis XIII-XIII of FIG 10.

### DETAILED DESCRIPTION OF EMBODIMENTS

Embodiments of the present invention are described below, by way of example only. It should be noted that details illustrated in the figures may not be drawn to scale. On the contrary, the dimensions of the details of the illustrations are chosen so as to improve the understanding of the present invention.

According to the present invention there is provided an electrical device having a voltage dependent capacitance. Such a device is also called a varactor. It will be appreciated that the varactor of the present invention may easily be integrated in a conventional CMOS process.

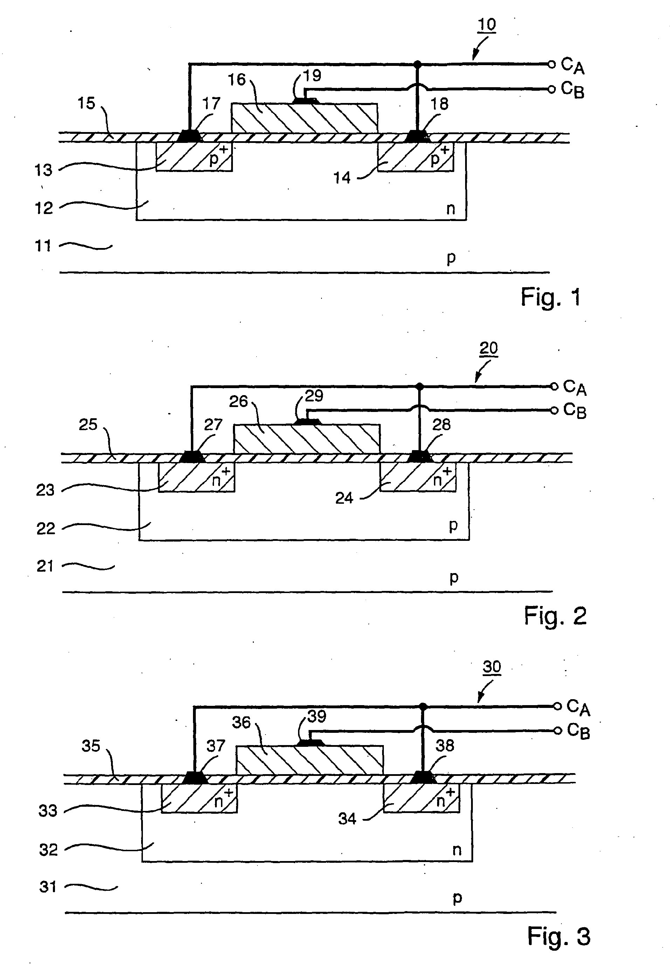

FIG 1 illustrates a varactor 10 comprising a PMOS enhancement transistor. The transistor is formed in a p-type silicon substrate 11. An n-type well 12 is formed in the p-type silicon substrate 11 from a first principal surface of the substrate and a p⁺-type source region 13 and a p⁺-type drain region 14 are formed in the n-type well 12. The impurity concentration of the source and drain regions 13, 14 is chosen to be greater than the impurity concentration of the well region 12. Thereafter an insulating layer 15, preferably of silicon oxide, is formed on the first principal surface of the substrate and a poly-silicon gate 16 is formed on the insulating layer 15 at least covering a part of the n-well region 12 separating the source region 13 and the drain region 14 and such that the gate 16 is electrically insulated from the n-well region 12. A common electrode C_{A} of the varactor 10 is formed by connecting the source region 13 to the drain region 14. Connection is made to the source region 13 and the drain region 14 by means of a source electrode 17 and a drain electrode 18, respectively. A second electrode C_{B} of the varactor 10 is connected to the gate 16 by means of a gate electrode 19.

FIG 2 illustrates a varactor 20 comprising a NMOS enhancement transistor. The transistor is formed in a p-type silicon substrate 21. A p-type well 22 is formed in the p-type silicon substrate 21 from a first principal surface of the substrate and an n⁺- type source region 23 and an n⁺-type drain region 24 are formed in the p-type well 22. The impurity concentration of the source and drain regions 23, 24 is chosen to be greater than the impurity concentration of the well region 22. Thereafter an insulating layer 25, preferably of silicon oxide, is formed on the first principal surface of the substrate and a poly-silicon gate 26 is formed on the insulating layer 25 at least covering a part of the p-well region 22 separating the source region 23 and the drain region 24 and such that the gate 26 is electrically insulated from the p-well region 22. A common electrode C_{A} of the varactor 20 is formed by connecting the source region 23 to the drain region 24. Connection is made to the source region 23 and the drain region 24 by means of a source electrode 27 and a drain electrode 28, respectively. A second electrode C_{B} of the varactor 20 is connected to the gate 26 by means of a gate electrode 29.

FIG 3 illustrates a varactor 30 comprising a NMOS depletion transistor. The transistor is formed in a p-type silicon substrate 31. An n-type well 32 is formed in the p-type silicon substrate 31 from a first principal surface of the substrate and an n⁺-type source region 33 and an n⁺-type drain region 34 are formed in the p-type well 32. The impurity concentration of the source and drain regions 33, 34 is chosen to be greater than the impurity concentration of the well region 32. Thereafter an insulating layer 35, preferably of silicon oxide, is formed on the first principal surface of the substrate and a poly-silicon gate 36 is formed on the insulating layer 35 at least covering a part of the n-well region 32 separating the source region 33 and the drain region 34 and such that the gate 26 is electrically insulated from the n-well region 32. A common electrode C_{A} of the varactor 30 is formed by connecting the source region 33 to the drain region 34. Connection is made to the source region 33 and the drain region 34 by means of a source electrode 37 and a drain electrode 38, respectively. A second electrode C_{B} of the varactor 30 is connected to the gate 36 by means of a gate electrode 39.

More generally the varactor can be defined as having a first region 12, 22, 32 of a semiconductor material in which a second region 13, 23, 33 and a third region 14, 24, 34 of a semiconductor material is formed. The second and third regions are separated by a separation region. An electrically insulating layer 15, 25, 35 is formed on the first region 12, 22, 32 at least at a region corresponding to the separation region. Thereafter, a substantially conductive element 16, 26, 36 is formed on the insulating layer 15, 25, 35 at least at a region corresponding to the separation region such that the insulating layer 15, 25, 35 electrically insulates the substantially conductive element 16, 26, 36 from the first, second and third regions. The substantially conductive element 16, 26, 36 is connected to an electrode C_{B} and the second and third regions are connected to a common electrode C_{A}.

It should be noted that the present invention is not limited to the use of semiconductor materials of silicon. Other semiconductor materials, *e.g.* GaAs, may be used instead. Furthermore, other materials than silicon oxide, *e.g*. silicon nitride or a combination of silicon oxide and silicon nitride, may be used to form the insulating layer 15, 25, 35. In those cases it is more appropriate to refer to Metal-Insulator-Semiconductor, MIS, transistors instead of Metal-Oxide-Semiconductor, MOS, transistors.

Although source electrodes 17, 27, 37 drain electrodes 18, 28, 38 and gate electrodes 19, 29, 39 are included in the embodiments discussed above, it should be understood that the present invention is not limited to the use of such electrodes. Instead the source region, the drain region and the gate may be connected by other means. For example, poly-silicon may be used for achieving a suitable connection to the gate and ion-implanted regions in the well-regions 12, 22, 32 or in the substrate 11, 21, 31 may be used to connect the source region 13, 23, 33 and the drain region 14, 24, 34. A combination of different methods of connection may be used for one and the same varactor.

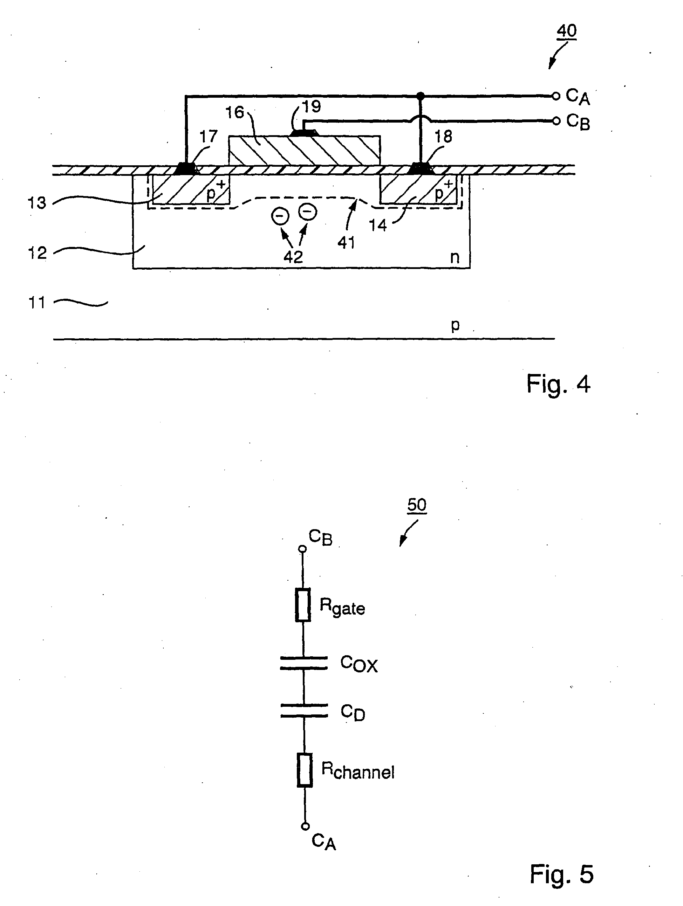

FIG 4 illustrates an operational aspect of the varactor of fig. 1. The varactor 40 corresponds to the varactor 10 of FIG 1 and FIG 5 illustrates an equivalent circuit diagram of the varactor 40. In operation, a voltage is applied between the electrodes C_{A} and C_{B} such that the potential at C_{A} is greater than the potential at C_{B}. The surface region of the well region 12 is then depleted and the depletion width is illustrated in FIG 4 by a depletion boundary 41. The capacitance of the varactor will, *inter alia,* be dependent on the series combination of the oxide capacitance Cₒₓ, or corresponding capacitance if the insulating layer is not made up of an oxide, and the semiconductor depletion layer capacitance C_{D}. The depletion layer capacitance C_{D} will, in its turn, be dependent on the potential of the well and on the voltage applied over the device, *i.e.* between the source/drain and the gate. A high dynamic range of the varactor is achieved by making the well region as lightly doped as possible at the principle surface region by, for example, blocking the threshold implantation of the CMOS process. A high Q factor of the varactors is also achieved by keeping the electrical resistance of the gate R_{gate} (and its connection) and the electrical resistance R_{channel} in the well region 12 between the source region 13 and the drain region 14 as small as possible. The electrical resistance of a poly-silicon gate may be decreased by including a step for siliciding the gate. The electrical resistance experienced by the minority charge carriers 42 in the well region 12 may be reduced by using small dimensions of the gate and the channel region. Small dimensions of the gate and the channel region do, however, give rise to a varactor having a capacitance with a sometimes unacceptable small numerical value. This problem is solved by connecting a suitable number of varactors in parallel to form a composite varactor. The connections between the varactors are preferably carried out by means of a low resistance material, such as aluminium, to keep the resistance between the devices low and thereby achieving an overall high Q factor of the composite varactor.

As mentioned above, the depletion layer capacitance C_{D} is also dependent on the potential of the well and, consequently, the device may also be operated by applying fixed potentials to the electrodes C_{A} and C_{B} and controlling the capacitance of the device by a suitable voltage applied to the well. Alternatively, a fixed potential is applied to one of the electrodes C_{A} or C_{B}, the other electrode is connected to the well and the device is controlled by a suitable voltage applied to the well.

The operational aspects of the first varactor of fig. 1 discussed above applies also to the second and third embodiments after appropriate adaptations to the applied polarities according to principles well known in the art.

Although the first, second and third varactors of fig. 1, 2 and 3 discussed above all makes use of a p-type semiconductor substrate, n-type semiconductor substrate may be used equally well if polarities and conductivity-types are adapted according to well known principles in the art.

In a conventional 0.25µm or 0.35µm CMOS process the gate length L_{g}, corresponding substantially to the distance between the source region and the drain region, is preferably chosen to be less than 2µm and most preferably less than 1µm. The gate width w_{g} is preferably chosen to be less than 20µm, *e.g.* 15µm, 10µm or 5µm. In the case where a low resistance gate material, such as metal silicided poly-silicon, is used the gate width may be chosen to be less than 6µm.

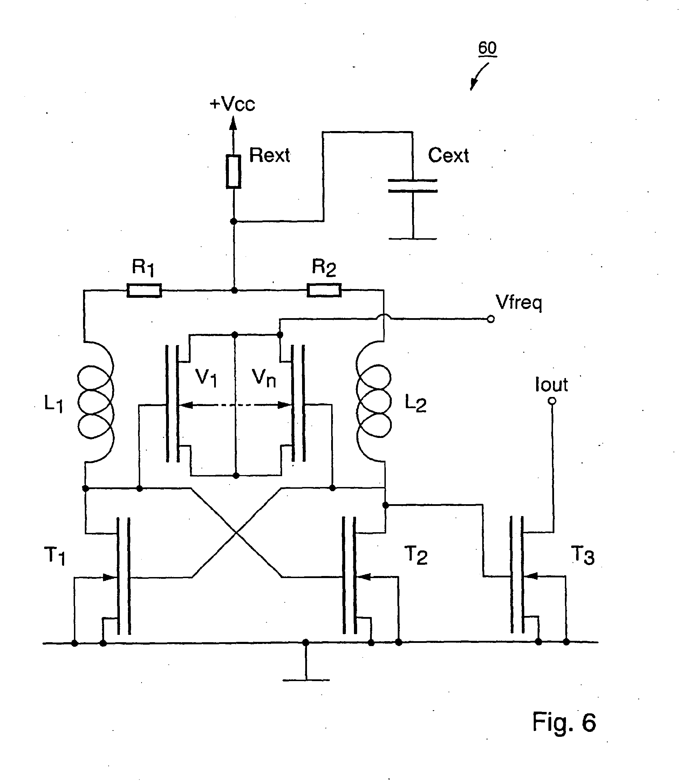

FIG 6 illustrates a circuit diagram of a Voltage Controlled Oscillator 60 according to a first embodiment of the present invention. The bulks and the sources of a first, a second and a third NMOS enhancement transistor, T₁, T₂, and T₃, respectively, are connected to ground potential. The gate of the first transistor T₁ is connected to the drain of the second transistor T₂ and to the gate of the third transistor T₃. The gate of the second transistor T₂ is connected to the drain of the first transistor T₁ and to a first electrode of first inductor L₁. A second electrode of the first inductor L₁ is connected to a first electrode of a first resistor R₁.

The drain of the second transistor T₂ is connected to a first electrode of a second inductor L₂. A second electrode of the second inductor is connected to a second resistor R₂. A second electrode of the first resistor R₁ is connected to a second electrode of the second resistor R₂ to a first electrode of a third resistor Rₑₓₜ and to a first electrode of a first capacitor Cₑₓₜ. A second electrode of the third resistor Rₑₓₜ is connected to a supply voltage +V_{cc} and a second electrode of the first capacitor Cₑₓₜ is connected to ground potential. The circuit further comprises at least two varactors V₁-Vₙ where n is the number of varactors. A first composite varactor is formed by coupling a predetermined number of the varactors V₁-Vₙ in parallel and a second composite varactor is formed by connecting the remaining varactors in parallel. An input connection for receiving a voltage V_{freq} which controls the frequency of the Voltage Controlled Oscillator is connected to a first electrode of each of the first and second composite varactors. A second electrode of the first composite varactor is connected to the drain of the first transistor T₁ and a second electrode of the second composite varactor is connected to the drain of the second transistor T₂. In this embodiment, the varactors V₁-Vₙ are made up of NMOS depletion transistors. The first electrodes of the composite varactors is constituted by a common connection between the bulk and all the source regions and drain regions of the NMOS depletion transistors. The second electrode of the first composite varactor is constituted by a common connection between the gates of the NMOS depletion transistors of the first composite varactor and the second electrode of the second composite varactor is constituted by a common connection between the gates of the NMOS depletion transistors of the second composite varactor. The gates of the NMOS depletion transistors are preferably connected to the VCO circuit, and not to the input connection for receiving a voltage V_{freq}, since the gate has a low parasitic capacitance. The output signal Iₒᵤₜ of the VCO is obtained at the drain of the third transistor T₃. Optionally the third resistor Rₑₓₜ and the first capacitor Cₑₓₜ are not integrated on the chip. Furthermore, it is possible to implement the first and second inductors L₁, L₂ by making use of the inductance of bonding wires of the IC. It should be noted that the bulk of the MOS transistors making up the composite varactors V₁-Vₙ may be connected to a different potential than V_{freq}, *e.g.* zero potential, as long as the bulk does not form a forward biased diode with any other regions of the transistors. The operation of the VCO circuit, as such, is well known in the art.

The best performance for a given VCO circuit with given inductors is determined by the Q factor and the dynamic range (minimum and maximum capacitance value) of the (composite) varactors. According to the fourth embodiment of the present invention NMOS transistors are used. These gives the lowest parasitic resistance and thus the highest Q factor. The threshold voltage is adjusted such as to give the largest dynamic range of the (composite) varactors as is possible within a pre-determined (voltage) bias range.

In the case where the varactors of the present invention are integrated in a conventional CMOS process together with other devices the source and drain regions need to be insulated from the substrate, for example by forming the varactor in at least one well region. Although a high dynamic range of the varactors is achieved by making the well region as lightly doped as possible at the principle surface region by, for example, blocking the threshold implantation of the CMOS process, this is not always necessary and, in those cases, conventional MOS transistors may be used. It should be noted that the integration of the varactor of the present invention may also be carried out in older CMOS processes where only one well region having a conductivity type opposite to the conductivity type of the substrate is available.

Advantageously, the present invention provides an integrated Voltage Controlled Oscillator and/or Phase Locked Loop, PLL, circuit (not shown), which include a varactor as discussed above, by using a conventional CMOS process. A PLL is often used in radio communication devices (not shown), such as portable/cellular phones, for synchronising signals with reference signals possibly received by means of a radio receiver and for generating desirable frequencies in a frequency synthesiser. Since many of the functions of a radio communication device may be integrated by conventional CMOS processes, the integration of a VCO and/or a PLL circuits together with these functions allows the present invention to provide a radio communication device with a high degree of integration and thus small physical dimensions. The high degree of integration also reduces the manufacturing costs.

Two more embodiments of (composite) varactors are presented below to illustrate that the electrical devices of the present invention may be implemented in a large number of ways without departing from the scope of the present invention.

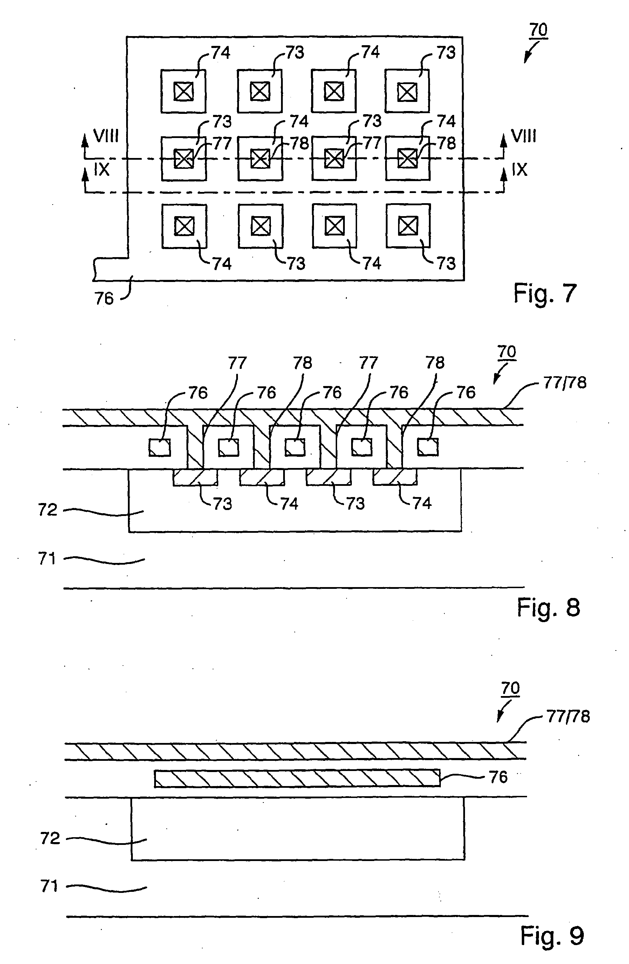

FIG 7 illustrates a top-view of a composite varactor 70 according to a second embodiment of the present invention. Furthermore, FIG 8 and FIG 9 illustrate cross-section views along the axes VIII-VIII and IX-IX, respectively, of FIG 7. An n-type well region 72 is formed in a p-type substrate 71. P⁺-type regions 73, 74 are formed in the well region 72 so as to form equally spaced islands in a two-dimensional matrix. A gate 76, separated from the well and the semiconductor substrate by an insulating layer (not shown), is formed at regions corresponding to regions between the p⁺-type regions 73, 74. Preferably, but not necessarily, the gate 76 also extends such that all p⁺-type regions are surrounded by the gate. The gate 76 forms a first electrode of the composite varactor 70. All p⁺-type regions 73, 74 are connected in common by means of a second layer of poly-silicon 77/78 and connecting elements 77, 78 and forms a second electrode of the composite varactor 70. The p⁺-type regions 73, 74 make up the source regions 73 and the drain regions 74 such that the closest regions to each source region 73 are drain regions 74 and *vice versa*.

In an example of a method of manufacturing the composite varactor 70 of the second embodiment the n-type well region 72 is first formed in the p-type semiconductor substrate 71. An insulating layer (not shown) is formed on the surface of the well region and a first poly-silicon layer is formed thereon. A first mask layer (not shown) is formed on the first poly-silicon layer. The first mask layer is exposed and etched to adopt a grid-shaped form (not shown). Next, the first poly-silicon layer is etched to form the gate 76. The gate 76 consequently adopts the grid-shaped form of the mask. The gate 76 forms the first electrode of the composite varactor. The remainder of the mask is removed and the p⁺-type source regions 73 and the p⁺-type drain regions 74 are formed by ion-implantation using the gate 76 as a mask. During this process the conductivity of the gate 76 will increase due to the ion-implantation of the gate. Alternatively, the mask is kept during the ion-implantation. Preferably, the conductivity of the gate is increased by having the gate 76 metal silicided. An insulating layer (not shown) is formed over the structure and a second mask layer (not shown) is formed thereon. The second mask layer is exposed and etched to form a mask (not shown) having openings over each of the source regions 73 and drain regions 74. Next, the insulating material in regulation with the openings will be removed in an etching step. The second mask is then removed and the second poly-silicon layer 77/78 is formed thereon. It should be noted that due to the previous etching step the second poly-silicon layer will connect to each of the source regions 73 and drain regions 74 by means of poly-silicon connecting elements 77 and 78, respectively. Thereby, the second poly-silicon layer 77/78 forms the second electrode of the composite varactor. In an alternative embodiment poly-silicon is used to form the connecting elements 77, 78 and a metal electrode is used, instead of the poly-silicon layer 77/78, to connect the connecting elements 77, 78 in common.

The device of the second embodiment can be considered as made up of a number of MOS transistors, each having a source region 73, a drain region 74, a gate 76 and a channel region formed between the source region 73 and the drain region 74, which are coupled in parallel by means of the second poly-silicon layer to form a composite varactor. The operation of each of the MOS transistors will therefore correspond to the operation of the varactors comprising a MOS transistor as discussed above.

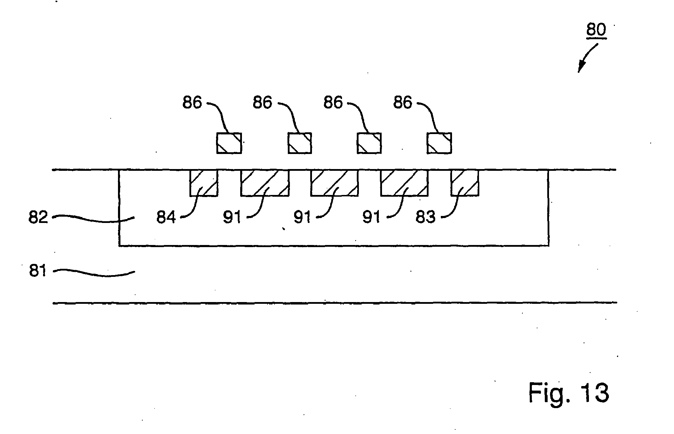

FIG 10 illustrates a top-view of a composite varactor 80 according to a third embodiment of the present invention. Furthermore, FIG 11, FIG 12 and FIG 13 illustrate cross-section views along the axes XI-XI, XII-XII and XIII-XIII, respectively, of FIG 10. An n-type well region 82 is formed in a p-type substrate 81. A p⁺-type region 83, 91, 84, 90 having a comb-shaped form is formed in the well region 82. A gate 86, separated from the substrate 81 and the well region 82 by an insulating layer (not shown), is formed at regions corresponding to the regions between the "fingers" of the comb-shaped p⁺-type region 83, 91, 84, 90. The gate 86 also extends along the edges of the "fingers" such that one common gate 86 is formed. The gate 86 forms a first electrode of the composite varactor 80 and the p⁺-type region 83, 91, 84, 90 is connected to a second electrode (not shown) of the composite varactor 80.

In an example of a method of manufacturing the composite varactor 80 of the third embodiment the n-type well region 82 is formed in the p-type semiconductor substrate 81. An insulating layer (not shown) is formed on the surface of the well region and a poly-silicon layer is formed thereon. A first mask layer (not shown) is formed on the poly-silicon layer. The first mask layer is exposed and etched to form a first mask (not shown) having a comb-shaped form. Next, the poly-silicon layer is etched to form the gate 86. The gate 86 consequently adopts the comb-shaped form of the mask. The gate 86 forms a first electrode of the composite varactor. The remainder of the mask is removed and a second mask layer (not shown) is formed on the structure. The second mask layer is exposed and etched to form a second mask (not shown) with an opening such that the "fingers" of the comb-shaped gate and an area surrounding the "fingers" are not covered by the mask. Thereafter, a p⁺-type source region 83, combined p⁺-type source and drain regions 91, a drain region 84 and connection regions 90 for connecting these regions are formed by ion-implantation using not only the second mask but also the gate 86 as a mask. During this process the conductivity of the gate 86 will increase due to the ion-implantation of the gate. Alternatively, the first mask is kept during the ion-implantation. Preferably, the conductivity of the gate is increase by having the gate 86 metal silicided. The ion-implanted regions 83, 91, 84 and 90 are connected and this connection forms a second electrode of the composite varactor.

The device of the third embodiment can be considered as made up of a number of MOS transistors, each having a source region 91 (or 83), a drain region 91 (or 84) a gate 86 and a channel region formed between the source region and the drain region, which are coupled in parallel by means of the connection regions 90 to form a composite varactor. The operation of each of the MOS transistors will therefore correspond to the operation of the varactors comprising a MOS transistor as discussed above. In an alternative embodiment (not shown) the gate 86 is formed (at least temporary during the manufacturing) such that it also performs the function of the second mask and, hence, no second mask is needed to define the regions which are to be ion-implanted 83, 91, 84 and 90 in the steps that follow.

The composite varactors (70, 80) of the second and third embodiments show examples of devices having a number of varactors coupled in parallel. As discussed above, a high Q factor of each varactor can be achieved by using small dimensions of the gate and the channel region and by keeping the resistance of the gate (and its connection) as small as possible. Small dimensions of the gate and the channel region do, however, give rise to a varactor having a capacitance with a sometimes unacceptable small numerical value. A suitable capacitance of a composite varactor, *e.g.* the composite varactors of the fifth and sixth embodiments (70, 80), is therefore achieved by coupling a suitable number of varactors in parallel. Composite varactors having high Q factors and suitable capacitances are thereby provided.

It should be noted that although the devices of the second and third embodiments have been illustrated by means of their method of manufacturing, other methods of manufacturing which may be contemplated by the man skilled in the art may be used without departing from the scope of the present invention. Furthermore, it is obvious that a device with any number of MOS transistors coupled together may be formed.

An advantage of the present invention is that varactor having high quality factors, Q, *i.e.* with low series resistance, may be realised even for high frequency applications by using a conventional CMOS process without adding any manufacturing steps. The varactors may therefore be manufactured at high yield and to low costs.

Furthermore, an advantage of the present invention is that a VCO is provided which may be realised by using a conventional CMOS process and which does not need the addition of a DC de-coupling capacitor to the design. This makes the implementation of the VCO inexpensive and physically small since no DC de-coupling capacitor is needed neither on the IC nor externally to the IC on the PCB. These advantages becomes even more pronounced when implemented in hand-held devices, such as portable phones, which need to be small and which are produced in high-volumes.

## Claims

1. A varactor (70; 80) having a voltage dependent capacitance between a first electrode and a second electrode **characterized in that** the varactor comprises:
at least two electrical devices in parallel, the electrical devices having voltage dependent capacitances; and **in that** the electrical device comprises:
a first region (12; 22; 32; 72; 82) of a semiconductor material; and
a second region (13; 23; 33; 73; 83, 91) and a third region (14; 24; 34; 74; 84, 91) of a semiconductor material formed in the first region, the second and third regions being separated by a separation region; and
an electrically insulating layer (15; 25; 35) formed on the first region at least at a region corresponding to the separation region; and
a conductive element (16; 26; 36; 76; 86) formed on the insulating layer at least at a region corresponding to the separation region such that the insulating layer electrically insulates the conductive element from the first, second and third regions; and
the first electrode connected to the conductive element; and
the second electrode connected to the second and third regions
**characterized in that**
the second region, the third region and the conductive element constitutes the drain, source and gate, respectively, of a MOS transistor; and
the gate length is less than 2µm; and
the drain and source regions and the conductive element are formed such that, in operation, a voltage dependent depletion layer is formed in the separation region and that a capacitive dynamic range is achieved by the corresponding voltage dependent depletion layer capacitance.

2. A varactor according to claim 1 wherein the conductive elements are connected to the first electrode by poly-silicon.

3. A varactor according to any one of claim 1 or claim 2 wherein the second and third regions are connected to the second electrode by regions of a semiconductor material.

4. A varactor according to claim 3 wherein the drains and sources form "fingers" of a comb-shaped form.

5. A varactor according to any one of claims 1 to 3 wherein the MOS transistors are lined up in a matrix.

6. A varactor according to claim 5 wherein the gate length is approximately 1 µm.

7. A varactor according to any one of claim 1 to claim 3 wherein the conductive element comprises metal silicide.

8. A varactor according to any one of claim 1 to claim 3 wherein the gate width is less than 5 µm.

9. A varactor according to any one of claim 1 to claim 3 wherein the gate width is less than 20 µm.

10. A varactor according to any one of the preceding claims wherein the first region (12; 22; 32; 72; 82) of a semiconductor material constitutes a well region in a semiconductor substrate (11; 21; 31; 71; 81) and wherein a third electrode is connected to the substrate.

11. A varactor according to claim 10 wherein the third electrode is connected to either the first or the second electrode.

12. A Voltage Controlled Oscillator (60) having an input terminal for the application of an input voltage and an output terminal for the outputting of an oscillating signal with a frequency depending on the input voltage, the Voltage Controlled Oscillator comprises a varactor having a voltage dependent capacitance according to any one of claim 1 to claim 11.

13. A Phase Locked Loop circuit comprising a varactor according to any one of claim 1 to claim 11.

14. A method of manufacturing an electrical device having a voltage dependent capacitance by means of a conventional CMOS process comprising the steps of:
forming a well region (72; 82) in a semiconductor substrate (70; 80);
forming a first insulating layer on the surface of the well region;
forming a first poly-silicon layer on the insulating layer;
forming a first mask layer on the first poly-silicon layer;
exposing the first mask layer and etching the mask layer;
etching the poly-silicon in areas where the first mask layer has been etched to form a gate (76; 86);
removing the remainder of the first mask layer;
forming a plurality of source regions and drain regions (73, 74; 83, 84, 91), separated by separation regions, the source and drain regions being aligned with the gate using the gate as a mask; **characterized in that** the method further comprises the steps of:
connecting the source regions with the drain regions; and
forming a blocking layer, for blocking a later MIS transistor threshold implantation step of an IC manufacturing process, at least at a region corresponding to the separation region.

15. A method of manufacturing an electrical device according to claim 14 wherein the source and drain regions are connected by regions formed by ion-implantation.

## Patentansprüche

1. Varaktor (70; 80) mit einer spannungsabhängigen Kapazität zwischen einer ersten Elektrode und einer zweiten Elektrode, **dadurch gekennzeichnet, dass** der Varaktor umfasst:
zumindest zwei parallele elektrische Vorrichtungen, wobei die elektrischen Vorrichtungen spannungsabhängige Kapazitäten aufweisen; und dadurch, dass die elektrische Vorrichtung umfasst:
einen ersten Bereich (12; 22; 32; 72; 82) eines Halbleitermaterials; und
einen zweiten Bereich (13; 23; 33; 73; 83; 91) und einen dritten Bereich (14; 24; 34; 74; 84; 91) eines in dem ersten Bereich ausgebildeten Halbleitermaterials, wobei der zweite und dritte Bereich durch einen Separationsbereich separiert ist; und
eine elektrische Isolierungsschicht (15; 25; 35), die auf dem ersten Bereich ausgebildet ist, zumindest auf einem Bereich, der mit dem Separationsbereich zusammenhängt; und
ein leitendes Element (16; 26; 36; 76; 86), das auf der Isolierungsschicht ausgebildet ist, zumindest auf einem Bereich, der mit dem Separationsbereich zusammenhängt, so dass die Isolierungsschicht das leitende Element von dem ersten, zweiten und dritten Bereichen elektrisch isoliert; und
die erste Elektrode, die mit dem leitenden Element verbunden ist; und
die zweite Elektrode, die mit dem zweiten und dritten Bereich verbunden ist;
**dadurch gekennzeichnet, dass**
der zweite Bereich, der dritte Bereich und das leitende Element jeweils den Drain, die Quelle und das Gate eines MOS-Transistors konstituiert; und
die Gate-Länge weniger als 2 µm ist; und
der Drain- und der Quellenbereich und das leitende Element so ausgebildet sind, dass im Betrieb eine Spannungs-abhängige Entleerungsschicht in der Separationsschicht ausgebildet wird und dass ein kapazitiver dynamischer Bereich durch die damit zusammenhängende spannungsabhängige Entleerungsschichtkapazität erhalten wird.

2. Varaktor nach Anspruch 1, wobei die leitenden Elemente mit der ersten Elektrode durch Polysilicon verbunden sind.

3. Varaktor nach irgendeinem der Ansprüche 1 oder 2, wobei der zweite und dritte Bereich mit der zweiten Elektrode durch Bereiche aus einem Halbleitermaterial verbunden sind.

4. Varaktor nach Anspruch 3, wobei die Drains und Quellen "Finger" einer kammartigen Form ausbilden.

5. Varaktor nach irgendeinem der Ansprüche 1 bis 3, wobei die MOS-Transistoren in einer Matrix aufgestellt sind.

6. Varaktor nach Anspruch 5, wobei die Gatelänge circa 1 µm ist.

7. Varaktor nach irgendeinem der Ansprüche 1 bis 3, wobei das leitende Element ein Metallsilizid umfasst.

8. Varaktor nach irgendeinem der Ansprüche 1 bis 3, wobei die Gatebreite weniger als 5 µm ist.

9. Varaktor nach irgendeinem der Ansprüche 1 bis 3, wobei die Gatebreite weniger als 20 µm ist.

10. Varaktor nach irgendeinem der vorhergehenden Ansprüche, wobei der erste Bereich (12; 22; 32; 72; 82) eines Halbleitermaterials einen Grabenbereich in einem Halbleitersubstrat (11; 21; 31; 71; 81) konstituiert und wobei eine dritte Elektrode mit dem Substrat verbunden ist.

11. Varaktor nach Anspruch 10, wobei die dritte Elektrode mit entweder der ersten oder der zweiten Elektrode verbunden ist.

12. Spannungsgesteuerter Oszillator (60) mit einem Eingabeterminal für das Anlegen einer Eingabespannung und einem Ausgabeterminal für die Ausgabe eines oszillierenden Signals mit einer von der Eingabespannung abhängigen Frequenz, wobei der spannungsgesteuerte Oszillator einen Varaktor mit einer spannungsabhängige Kapazität nach irgendeinem der Ansprüche 1 bis 11 umfasst.

13. Phasenregelkreisschaltung, einen Varaktor nach irgendeinem der Ansprüche 1 bis 11 umfassend.

14. Verfahren zum Herstellen einer elektrischen Vorrichtung mit einer spannungsabhängigen Kapazität mittels eines konventionellen CMOS-Prozesses, die Schritte umfassend:
Ausbilden eines Grabenbereiches (72; 82) in einem Halbleitersubstrat (70; 80);
Ausbilden einer ersten Isolierungsschicht auf der Oberfläche des Grabenbereichs;
Ausbilden einer ersten Polysilicon-Schicht auf der Isolierungsschicht;
Ausbilden einer ersten Maskenschicht auf der ersten Polysilicon-Schicht;
Aussetzen der ersten Maskenschicht und Ätzen der Maskenschicht;
Ätzen des Polysilicons in Bereichen, in denen die erste Maskenschicht geätzt wurde, um ein Gate (76; 86) auszubilden;
Entfernen des Rests der ersten Maskenschicht;
Ausbilden einer Vielzahl von Quellenbereichen und Drainbereichen (73; 74; 83; 84; 91), die durch Separationsbereiche separiert sind, wobei die Quellen- und Drainbereiche mit dem Gate unter Verwendung des Gates als Maske ausgerichtet sind; **dadurch gekennzeichnet, dass** das Verfahren ferner die Schritte umfasst:
Verbinden der Quellenbereiche mit den Drainbereichen; und
Ausbilden einer Blockierschicht zum Blockieren eines späteren MIS-Transistor-Schwellenwert-Implantationsschrittes eines IC-Herstellungsprozesses, zumindest in einem Bereich, der mit der Separierungsschicht verbunden ist.

15. Verfahren zum Herstellen einer elektrischen Vorrichtung nach Anspruch 14, wobei die Quellen- und Drainbereiche durch die Bereiche verbunden sind, die durch eine Ionen-Implantation ausgebildet sind.

## Revendications

1. Diode à capacité variable (70 ; 80) ayant une capacité dépendant de la tension entre une première électrode et une deuxième électrode, **caractérisée en ce que** la diode à capacité variable comprend :
au moins deux dispositifs électriques en parallèle, les dispositifs électriques ayant des capacités dépendant de la tension, et **en ce que** le dispositif électrique comprend :
une première région (12 ; 22 ; 32 ; 72 ; 82) d'un matériau semiconducteur, et
une deuxième région (13 ; 23 ; 33 ; 73 ; 83, 91) et une troisième région (14 ; 24 ; 34 ; 74 ; 84, 91) d'un matériau semiconducteur formées dans la première région, la deuxième région et la troisième région étant séparées par une région de séparation, et
une couche électriquement isolante (15 ; 25 ; 35) formée sur la première région au moins au niveau d'une région correspondant à la région de séparation, et
un élément conducteur (16 ; 26 ; 36 ; 76 ; 86) formé sur la couche isolante au moins au niveau d'une région correspondant à la région de séparation de sorte que la couche isolante isole électriquement l'élément conducteur des première, deuxième et troisième régions, et
la première électrode connectée à l'élément conducteur, et
la deuxième électrode connectée aux deuxième et troisième régions,
**caractérisée en ce que**
la deuxième région, la troisième région et l'élément conducteur constituent le drain, la source et la grille, respectivement, d'un transistor de type MOS, et
la longueur de grille est inférieure à 2 µm, et
les régions de drain et de source et l'élément conducteur sont formés de sorte que, en fonctionnement, une couche de déplétion dépendant de la tension soit formée dans la région de séparation et qu'une plage dynamique de capacité soit atteinte par la capacité de la couche de déplétion dépendant de la tension correspondante.

2. Diode à capacité variable selon la revendication 1, dans laquelle les éléments conducteurs sont connectés à la première électrode par du polysilicium.

3. Diode à capacité variable selon l'une quelconque de la revendication 1 ou de la revendication 2, dans laquelle les deuxième et troisième régions sont connectées à la deuxième électrode par des régions d'un matériau semiconducteur.

4. Diode à capacité variable selon la revendication 3, dans laquelle les drains et les sources forment des "doigts" d'une forme de peigne.

5. Diode à capacité variable selon l'une quelconque des revendications 1 à 3, dans laquelle les transistors de type MOS sont alignés dans une matrice.

6. Diode à capacité variable selon la revendication 5, dans laquelle la longueur de grille est d'approximativement 1 µm.

7. Diode à capacité variable selon l'une quelconque des revendications 1 à 3, dans laquelle l'élément conducteur comprend du siliciure de métal.

8. Diode à capacité variable selon l'une quelconque des revendications 1 à 3, dans laquelle la largeur de grille est inférieure à 5 µm.

9. Diode à capacité variable selon l'une quelconque des revendications 1 à 3, dans laquelle la largeur de grille est inférieure à 20 µm.

10. Diode à capacité variable selon l'une quelconque des revendications précédentes, dans laquelle la première région (12 ; 22 ; 32 ; 72 ; 82) d'un matériau semiconducteur constitue une région de puits dans un substrat semiconducteur (11 ; 21 ; 31 ; 71 ; 81) et dans laquelle une troisième électrode est connectée au substrat.

11. Diode à capacité variable selon la revendication 10, dans laquelle la troisième électrode est connectée à l'une ou l'autre de la première et de la deuxième électrodes.

12. Oscillateur commandé en tension (60) ayant une borne d'entrée pour l'application d'une tension d'entrée et une borne de sortie pour la sortie d'un signal oscillant avec une fréquence dépendant de la tension d'entrée, l'oscillateur commandé en tension comprend une diode à capacité variable ayant une capacité dépendant de la tension selon l'une quelconque des revendications 1 à 11.

13. Circuit à boucle à verrouillage de phase comprenant une diode à capacité variable selon l'une quelconque des revendications 1 à 11.

14. Procédé de fabrication d'un dispositif électrique ayant une capacité dépendant de la tension au moyen d'un procédé CMOS classique comprenant les étapes consistant à :
former une région de puits (72 ; 82) dans un substrat semiconducteur (70 ; 80),
former une première couche isolante sur la surface de la région de puits,
former une première couche de polysilicium sur la couche isolante,
former une première couche de masque sur la première couche de polysilicium,
exposer la première couche de masque et attaquer la couche de masque,
attaquer le polysilicium dans des zones où la première couche de masque a été attaquée pour former une grille (76 ; 86),
éliminer le reste de la première couche de masque,
former une pluralité de régions de sources et de régions de drains (73, 74 ; 83, 84, 91), séparées par des régions de séparation, les régions de sources et de drains étant alignées avec la grille en utilisant la grille en tant que masque, **caractérisé en ce que** le procédé comprend en outre les étapes consistant à :
connecter les régions de sources aux régions de drains, et
former une couche de blocage, destinée à bloquer une étape ultérieure d'implantation de seuil de transistor MIS d'un procédé de fabrication d'un circuit intégré, au moins au niveau d'une région correspondant à la région de séparation.

15. Procédé de fabrication d'un dispositif électrique selon la revendication 14, dans lequel les régions de sources et de drains sont connectées par des régions formées par implantation ionique.
